# EUROPÄISCHE PATENTSCHRIFT

(11) **EP 0 831 980 B1**
(45) Veröffentlichungstag und Bekanntmachung des Hinweises auf die Patenterteilung: **09.07.2003**
(21) Anmeldenummer: 97918122.9
(22) Anmeldetag: 09.04.1997
(51) Int. Cl.: B23K 26/06

(54) **MATERIALBESTRAHLUNGSGERÄT UND VERFAHREN ZUM BETRIEB VON MATERIALBESTRAHLUNGSGERÄTEN**
MATERIAL-IRRADIATION DEVICE AND PROCESS FOR OPERATION OF MATERIAL-IRRADIATION DEVICES
APPAREIL DE TRAVAIL DE MATERIAUX PAR EXPOSITION A DES RAYONNEMENTS ET PROCEDE PERMETTANT DE FAIRE FONCTIONNER DES APPAREILS DE CE TYPE

(30) Priorität: 09.04.1996 DE 19614050
(43) Veröffentlichungstag der Anmeldung: 01.04.1998
(73) Patentinhaber: Carl Zeiss, 89518 Heidenheim (Brenz) (DE); CARL-ZEISS-STIFTUNG, HANDELND ALS CARL ZEISS, 89518 Heidenheim (Brenz) (DE)
(72) Erfinder: SCHWEIZER, Jürgen, D-73463 Westhausen (DE)
(74) Vertreter: Gnatzig, Klaus
(86) Internationale Anmeldenummer: EP9701748
(87) Internationale Veröffentlichungsnummer: WO97037807

(56) Entgegenhaltungen:
- EP-A- 0 683 007
- WO-A-94/16875
- US-A- 5 290 992
- PATENT ABSTRACTS OF JAPAN vol. 014, no. 271 (M-0983), 12.Juni 1990 & JP 02 080190 A (TOSHIBA CORP), 20.März 1990,

## Beschreibung

Die Erfindung betrifft ein Materialbestrahlungsgerät nach dem Oberbegriff des Anspruches 1.

Ein derartiges Materialbearbeitungsgerät ist aus der JP-A 02080190 bekannt. Dieses Gerät weist hinter dem Laser einen Umlenkspiegel und nachfolgend im umgelenkten Strahlengang mehrere hinter einander angeordnete Strahlteiler auf, durch die der Laserstrahl in mehrere Teilstrahlen aufgeteilt wird. Zur Einstellung unterschiedlicher Abstände der Auftreffpunkte der Teilstrahlen auf dem zu bearbeitenden Werkstück ist die alle Strahteiler umfassende Gesamteinheit um eine in der Ebene des Umlenkspiegels liegende Achse drehbar, wobei bei einer Drehung der Gesamteinheit der Umlenkspiegel entsprechend nachgeführt wird. Auch bei einer Drehung der Gesamteinheit bleiben jedoch die Auftreffpunkte der Teilstrahlen auf dem zu bearbeitenden Werkstück äquidistant.

Eine weiteres Materialbestrahlungsgerät ist aus der EP-A 0683007 bekannt. Dort wird zur Aufteilung des Bearbeitungsstrahls ein Linsenarray eingesetzt. Zur individuellen Manipulation der einzelnen Strahlen sind dem Linsenarray Kippspiegelanordnungen nachgeschaltet. Hier ist die Dimensionierung der Kippspiegelanordnung, die komplett innerhalb des Strahldurchmessers des aufgeweiteten Strahls angeordnet sein muß, schwierig.

Insbesondere für das Bohren vom Laminaten wie z.B. eine 50 µm dicke Polyimid-Folie die beidseitig mit z.B. 17 µm Kupfer laminiert ist (ein Ausgangsprodukt in der Leiterplattenindustrie, das heute bereits lasertechnisch bearbeitet wird) und in die ein sogenanntes Sackloch gebohrt werden soll, das durch die obere Kupferschicht und das Polyimid hindurchgeht und die untere Kupferschicht als Boden hat (siehe Bild 1), gibt es heute mit dem Laser folgende Möglichkeiten:

Bei einem ersten Verfahren nach dem Stand der Technik erfolgt die Erzeugung der Eintrittslöcher in der oberen Kupferlage auf fototechnisch-chemischem Weg. Dann wird durch Laserbohren des Polyimids durch das geöffnete Kupfer hindurch mit einer Energiedichte von z.B. 0,7 J/cm², die das Polyimid gut bearbeitet aber Kupfer noch nicht angreift, das Polyimid entfernt. Die untere Kupferschicht wirkt dann automatisch als Stoppschicht für den Laser. Als typischer Laser wird hierbei ein gepulster UV-Laser verwendet.

Der Nachteile dieses Verfahrens ist darin zu sehen, daß außer der Bestrahlung durch den Laser zusätzliche Arbeitsprozesse zur Erzeugung der Eintrittslöcher in der oberen Kupferlage auf fototechnisch-chemischem Weg erforderlich sind.

Ein zweites nach dem Stand der Technik bekannte Verfahren ist dem ersten ähnlich, jedoch wird eine. Laser verwendet, der vom Kupfer reflektiert wird und daher das Kupfer nicht angreift. Das erlaubt höhere Energiedichten und somit eine etwas schnellere Bearbeitung des Polyimids. Der Erhöhung der Energiedichte sind jedoch Grenzen gesetzt (ca. 2 J/cm²), da sonst das Polyimid thermisch geschädigt wird und die Lochränder verbrannt werden und sich dann nicht mehr metallisieren lassen. Ein typische Laser zur Durchführung dieses Verfahrens ist ein gepulster C02-Laser.

Der Nachteil dieses Verfahrens ist darin zu sehen, daß zusätzliche Arbeitsprozesse zur Erzeugung der Eintrittslöcher in der oberen Kupferlage auf fototechnisch-chemischem Weg erforderlich sind. Auf dem unteren Kupferboden bleibt zudem ein ca. 0,7 µm dicker Polyimidbelag zurück.

Ein drittes nach dem Stand der Technik bekannte Verfahren verwendet unterschiedliche Laser für die Entfernung der Kupferschicht und des Polyimid. Z.B. wird ein Nd-YAG Laser mit hoher Energiedichte (z.B. 20 J/cm²) zum Bohren der oberen Kupferschicht und ein UV- oder C02-Laser zum Bohren des Polyimids verwendet.

Der Nachteil dieses Verfahrens ist darin zu sehen, daß zwei unterschiedliche Laser erforderlich sind und die verwendeten Optiken auf beide Wellenlängen ausgelegt sein müssen.

Bei einem vierten nach dem Stand der Technik bekannten Verfahren erfolgt die Bearbeitung des Laminats mit einem UV-Laser derart, daß mit hoher Energiedichte die obere Kupferschicht gebohrt wird und dann die Energiedichte durch Defokussierung des Strahls oder Einschwenken eines Filters derart gesenkt wird, daß der Strahl zwar das Polyimid bearbeitet, aber nicht mehr das Kupfer angreift.

Auch dieses Verfahren hat Nachteile. Da sich Laser in ihrem Energieausstoß kaum regeln lassen, wird hier bei der Bearbeitung des Polyimid Energie verschwendet. Folglich kann die Leistungsfähigkeit des Lasers nicht ausgenutzt werden, was letztendlich eine verringerte Produktivität bedeutet.

Es ist die Aufgabe der Erfindung ein Materialbestrahlungsgerät, welches höchste Funktionalität unter Verwendung eines minimalen technischen Aufwandes schafft und ein energetisch günstiges Verfahren zum Einsatz von Materialbestrahlungsgeräten zu finden.

Diese Aufgabe wird erfindungsgemäß durch ein Materialbestrahlungsgerät mit den Merkmalen des Anspruches 1 gelöst.

Das erfindungsgemäße Bestrahlungsgerät zeichnet sich dadurch aus, daß es sehr einfach aufgebaut ist und dennoch eine sehr hohe Flexibilität besitzt.

Vorzugsweise kann der Strahlquerschnitt jedes Teilstrahls anders fokussiert sein (vorzugsweise nach der Strahlteilung) und damit eine unterschiedliche Aufgabe erfüllt werden kann.

Im Zusammenspiel zwischen Werkstückbewegungseinrichtung (welche eigentlich nur in einer Achse eine Bewegung des Werkstückes ermöglichen muß und somit als Laufband ausgestaltet sein kann) und der Strahlteilungseinrichtung und/oder einer zusätzlichen Strahlumlenkeinrichtung kann jedes Flächenstück auf der Oberfläche des Werkstücks durch das Materialbestrahlungsgerät bearbeitet werden, wobei die Art der Bearbeitung (z.B. Erwärmen, Belichten, Bohren, usw.) auf ein und demselben Flächenstück unterschiedlich sein kann.

Ein derartiges Gerät ist relativ einfach aufgebaut und ist ideal zur Verbindung mit einer Steuerung geeignet. Außerdem können die unterschiedlichsten Bearbeitungsarten an einem Punkt oder auf einer Fläche gleichzeitig erfolgen. Denkbar wäre zum Beispiel das Bohren eines Loches durch einen Strahl, welcher sehr scharf fokussiert ist, und das gleichzeitige Erwärmen der Bohrlochumgebung zur Sicherstellung einer besseren Verbindung der Werkstückoberfläche mit einem aufgesprühten oder aufgelegten leitenden Material (z.B. für Leiterplatten).

Die Anzahl der Teilstrahlen ist im Prinzip unbegrenzt, wobei gleichzeitig mehrere Teilstrahlen parallel zueinander an einer oder unterschiedlicher Stelle auf das Werkstück fallen können.

Dabei können mehrere gleichartige Anordnungen nebeneinander angeordnet werden, so daß gleichzeitig eine ganze Fläche an den unterschiedlichsten Stellen einfach oder auch gleichzeitig mehrfach parallel bearbeitet werden können.

Je höher die Anzahl der Teilstrahlen ist, umso größer muß die Leistung der Strahlquelle sein. Deshalb wird man in den meisten Fällen einen Laser als Strahlquelle verwenden müssen.

Um einen einfachen und flexiblen Aufbau des Gerätes zu erhalten, sollte die optische Achse aus der Strahlquelle möglichst nicht mit den optischen Achsen der Teilstrahlen in einer Richtung verlaufen.

Zur Erzeugung der Teilstrahlen eignen sich insbesondere Strahlteiler, welche einen Strahlteil ungestört hindurch lassen und einen anderen Strahlteil ablenken. Hierbei ist insbesondere an teildurchlässige Strahlenteiler (Strahlteilerwürfel) zu denken. Der aus der Strahlenquelle austretende Strahl sollte aber schon vor der Strahlteilung einen geeigneten Strahlquerschnitt erhalten und in seiner Divergenz falls nötig angepaßt werden.

Weitere vorteilhafte Merkmale der Erfindung sind in den Unteransprüchen angegeben.

Die Vorteile des erfindungsgemäßen Verfahrens sind in der nun folgenden Beschreibung dargelegt.

Die Erfindung wird im folgenden in beispielhafter Weise anhand von Zeichnungen erläutert, wobei weitere wesentliche Merkmale sowie dem besseren Verständnis dienende Erläuterungen und Ausgestaltungsmöglichkeiten des Erfindungsgedankens beschrieben sind.

Dabei zeigen:
- Figur 1: ein erfindungsgemäßes Bestrahlungsgerät;
- Figur 2: eine Variante des erfindungsgemäßen Bestrahlungsgeräts aus Figur 1;
- Figur 3: eine weitere Variante des erfindungsgemäßen Bestrahlungsgeräts aus Figur 1;
- Figur 4: einen erfinderisch modifizierten Strahlteilerwürfel;
- Figur 5: eine weitere Variante eines erfinderisch modifizierten Strahlteilerwürfels;
- Figur 6: eine Variante des erfindungsgemäßen Bestrahlungsgeräts;
- Figur 7: eine Detailansicht des Strahlteilers in Figur 6;
- Figur 8: die Kontrolleinrichtung zur Ermittlung der Position der Einzelstrahlen aus Figur 6;
- Figur 9: die Steuerung für das Bestrahlungsgerät aus Figur 6; und
- Figur 10: eine Einrichtung zur Strahlverbesserung für das Bestrahlungsgerät aus Figur 6.

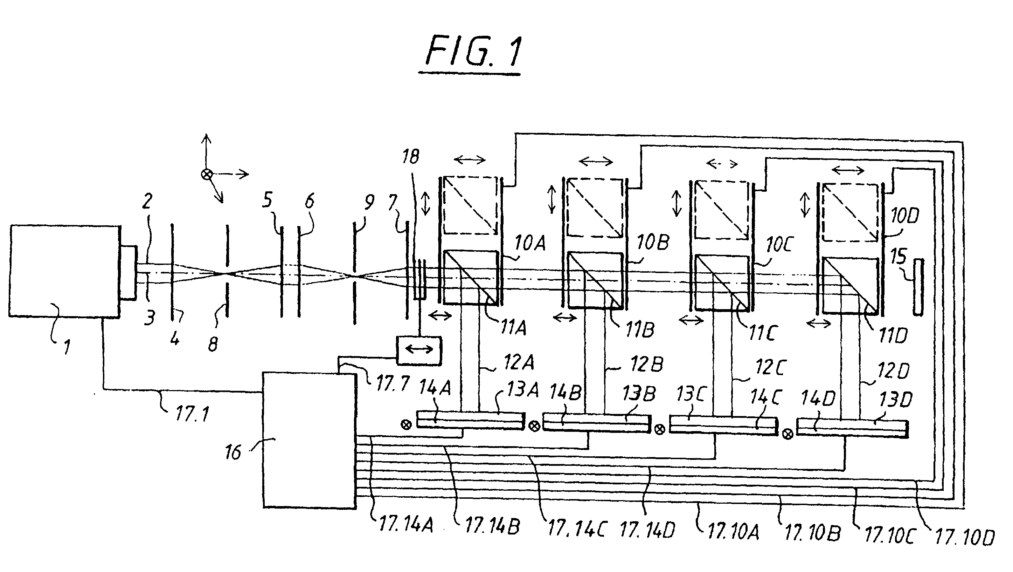

Das in der Figur 1 beispielhaft dargestellten Bestrahlungsgerät besitzt als Strahlquelle (1) einen Excimer-Laser. Es könnte aber auch jeder beliebige gepulste Laser oder Dauerstrich-Laser (vorteilhafterweise mit einer Wellenlänge zwischen 190 und 3000 nm, aber auch CO₂-Laser sind teilweise vorteilhaft) sein, wobei je nach Wellenlänge die speziell für diese Wellenlänge geeigneten optischen Komponenten (linsen, Spiegel, usw.) auszusuchen sind, welche den Laserstrahl insbesondere führen und formen können.

Der aus der Strahlquelle (1) auscretende Bearbeitungsstrahl (2) besitzt eine optische Achse (3), auf welcher im wesentlichen alle weiteren optischen Bauteile angeordnet sind.

Hinter der Strahlquelle (1) befindet sich eine erste Zylinderlinsenbaugruppe (4, 5) zur ersten Formung des Bearbeitungsstrahls (2) in einer Strahlauerschnittsachse. Zwischen den beiden Linsen (4, 5) ist ein erstes spaltenförmiges Divergenzfilter (8) angeordnet, mit welchem die Divergenz des Bearbeitungsstrahls (2) in einer Strahlquerschnittsachse angepaßt wird.

Hinter dieser ersten Zylinderlinsenbaugruppe (4, 5) befindet sich eine zweite Zylinderlinsenbaugruppe (6, 7) zur einer weiteren Formung des Bearbeitungsstrahls (2) in einer zur ersten Achse senkrechten Richtungsachse. Zwischen den beiden Linsen (6, 7) ist ein zweites spaltenförmiges Divergenzfilter (9) angeordnet, mit welchem die Divergenz des Bearbeitungsstrahls (2) in einer zur ersten Achse senkrecht stehenden Strahlquerschnittsachse angepaßt wird.

Nach der zweiten Zylinderlinsenbaugruppe ist ein Zoom-Objektiv (18) eingefügt, um den Strahlquerschnitt zu variieren.

Nachdem nun der Bearbeitungsstrahl (2) sowohl im Strahlquerschnitt als auch in seiner achsialen Divergenz die gewünschten und vorgegebenen Werte erfüllt, fällt er auf eine erste Strahlteilungseinrichtung (10A), welche einen Strahlteilungswürfel (11A) mit einer Strahlteilungsschicht in seinem Inneren beinhaltet. Die Strahlteilungseinrichtung (10A) besitzt im Bereich der optischen Achse (3) entsprechend große Öffnungen, durch welchen der Bearbeitungsstrahl (2) ungestört hindurchgehen kann.

Befindet sich der Strahlteilungswürfel (11A) auf der optischen Achse (3), so läßt er einen Teil des auf ihn auffallenden Bearbeitungsstrahls (2) ungestört hindurch. Ein anderer Bearbeitungsteilstrahl (12A) wird durch ihn aber als Teilstrahl aus dem Bearbeitungsstrahl (2) ausgekoppelt und fällt auf ein zu bearbeitendes Werkstück (13A), welches auf einem Förderband (14A) aufliegt.

Dieses Förderband (14A) kann das Werkstück (13A) senkrecht zur Zeichnungsebene bewegen. Die Strahlteilungseinrichtung (10A) kann eine Bewegung parallel zur optischen Achse (3) und somit senkrecht zur Bewegungsachse des Förderbandes (14A) ausführen, sodaß die Kombination der beiden Bewegungen sicherstellt, daß jeder Bereich der Oberfläche des Werkstücks (13A) für den Bearbeitungsteilstrahl (12A) erreichbar ist.

Entsprechendes gilt für die folgenden Strahlteilungseinrichtungen (10B, 10C, 10D), Strahlteilungswürfel (11B, 11C, 11D), Bearbeitungsteilstrahlen (12B, 12C, 12D), Werkstücke (13B, 13C, 13D) und Förderbänder (14B, 14C, 14D). Dabei kann der letzte Strahlteilungswürfel (11D) aber anstelle der Strahlteilungsschicht eine Verspiegelungsschicht besitzen.

Hinter der letzen Strahlteilungseinrichtung (10D) ist noch eine Strahlabsorptionswand (15) angeordnet. Diese Strahlabsorpticnswand (15) ist notwendig, da alle Strahlteilungswürfel (11A, 11B, 11C, 11D) in den Strahlteilungseinrichtungen (10A, 10B, 10C, 10D) aus der optischen Achse (3) entfernbar sind und zwar dann, wenn der entsprechende Bearbeitungsteilstrahl (12A, 12B, 12C, 12D) nicht benötigt wird. (Sie kann allerdings auch Bestandteil der letzten Strahlteilungseinrichtung (10D) sein in Abweichung zur Darstellung in der Figur 1.)

Da die Zeichnung nur beispielhaft sein soll, versteht es sich, daß die Anzahl der Strahlteilungseinrichtungen (10) und der entsprechenden anderen Bauteile größer oder kleiner als in der Zeichnung dargestellt sein kann.

Das Materialbestrahlungsgerät beinhaltet auch eine Steuerung (15), welche mit allen zu steuernden Bauteilen und Baugruppen (1, 1CA, 10B, 10C, 10D, 14A, 143, 14C, 14D, 18) über Leitungen (17.1, 17.7, 17.10A, 17.10B, 17.10C, 17.10D, 17.14A, 17.14B, 17.14C, 17.14D) verbunden ist. Die Steuerung (16) steuert dabei wahlweise insbesondere die Strahlquelle (1), die Relativbewegung des Zoom-Objektivs (18), die Auf- und Abbewegung der Strahlteilungswürfel (11A, 11B, 11C, 11D) in den Strahlteilungseinrichtungen (10A, 10B, 10C, 10D) und die Vorwärts- bzw. Rückwärtsbewegung der Förderbänder (14A, 14B, 14C, 14D).

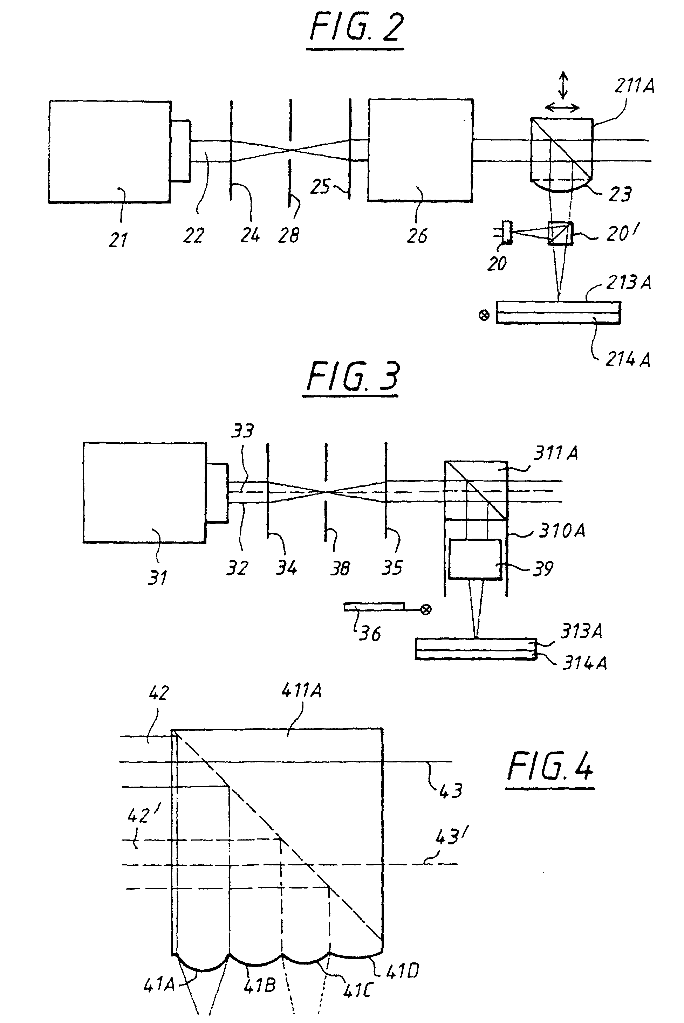

In Figur 2 ist eine leicht abgewandelte Variante des in der Figur 1 dargestellten Materialbestrahlungsgerätes dargestellt. Im Unterschied zu dem in Figur 1 dargestellten Gerät ist hierbei vor dem ersten Strahlteilungswürfel (211A) ein Strahlhomogenisator (26) nach bekanntem Stand der Technik angeordnet, welcher die Energieverteilung im Querschnitt des Bearbeitungsstrahls (22) homogenisiert.

Außerdem befindet sich zwischen Strahlteilungswürfel (211A) und Werkstück (213A) ein weiterer Strahlteilungswürfel (20'), welcher einen geringen Anteil des Teilstrahlungsbündels auf eine Fotodiode (20) lenkt. Diese Fotodiode (20) mißt die Intensität des Bearbeitungsteilstrahlenbündels und diese Meßergebnis kann dann der in dieser Figur nicht dargestellten Steuerung (16 aus Figur 1) zugeführt werden, welche den Meßwert zur Regulierung der Leistungsabgabe der Strahlquelle (21) verwendet.

Eine weitere Variation betrifft die Linsenbaugruppe (24, 25) mit dem in ihr integrierten Divergenzfilter (28). Die Linsen der Linsenbaugruppe (24, 25) sind hier sphärisch gestaltet und das Divergenzfilter (28) ist als Lochblende ausgeführt.

Desweiteren besitzt der Strahlteilungswürfel (211A) eine Strahlaustrittsfläche (23) für den Teilstrahl, welche den aus ihr austretenden Teilstrahl fokussiert.

Die Werkstückbewegungseinrichtung (214A) ist als Koordinatentisch ausgeführt, welche eine Bewegung des Werkstücks (213A) zumindest in einer Achse senkrecht zur Zeichnungsebene ermöglicht.

In der Figur 3 sind die rotationssymmetrischen Linsen der Linsenbaugruppe (34, 35) relativ zueinander festgelegt und das Divergenzfilter (38) ist als verstellbare Blende ausgeführt.

Der Strahlteilungswürfel (311A) verbleibt immer in der optischen Achse (33) des Bearbeitungsstrahls (32). Soll der aus dem Bearbeitungsstrahl (32) ausgekoppelte Teilstrahl abgeschaltet werden, so wird bei dieser Variation des in der Figur 3 dargestellten Materialbestrahlungsgeräts eine Strahlabsorptionswand (36) vor die Strahlteilungseinrichtungen (310A) geschwenkt.

Hinter dem Strahlteilungswürfel (311A) ist ein Zoom-Objektiv (39) angeordnet, welches von der Steuerung (16 in Figur 1) seine Bewegungsbefehle erhält. Die Strahlabsorptionswand (36) muß nach dem Strahlteilungswürfel (311A) und vor bzw. hinter dem Objektiv (39) ausschwenkbar angeordnet sein.

In der Figur 4 ist ein modifizierter Strahlteilungswürfel (411A) dargestellt. Dieser Strahlteilerwürfel (411A) ist größer als notwendig ausgeführt, sodaß der Bearbeitungsstrahl (42, 42') an unterschiedlichen Stellen verlassen kann. Während der Bearbeitungsstrahl (42, 42') immer an einer ebenen Fläche in den Strahlteilerwürfel (411A) eintritt, ist die Austrittsfläche (41A, 41B, 41C, 41D) des Strahlteilerwürfels (411A) linsenförmig ausgebildet, um den in Richtung auf das hier nicht eingezeichnete, zu bearbeitende Werkstück ausgestrahlten Teilstrahl auf der Werkstückoberfläche zu fokussieren.

Trifft nun der Bearbeitungsstrahl (42) im oberen Bereich der Strahlteilerschicht auf den Strahlteilerwürfel (411A), so wird der Teilstrahl durch die Strahlaustrittsfläche (41A) fokussiert. Trifft hingegen der Bearbeitungsstrahl (42) im unteren Bereich der Strahlteilerschicht auf den Strahlteilerwürfel (411A), so wird der Teilstrahl durch die Strahlaustrittsfläche (41C) fokussiert. Um den Teilstrahl an einer Bestrahlung der Werkstückoberfläche zu hindern, kann ggf. eine oder mehrere Strahlaustrittsflächen (41D) als Strahlabsorptionswand ausgebildet sein.

Die Auswahl der jeweils gewünschten Strahlaustrittsflächen (41) erfolgt durch anheben oder absenken (je nach Realisierung des Strahlteilerwürfels auch durch eine seitliche Versetzung) des Strahlteilerwürfels (411A) relativ zur optischen Achse (43) des Bearbeitungsstrahls (42).

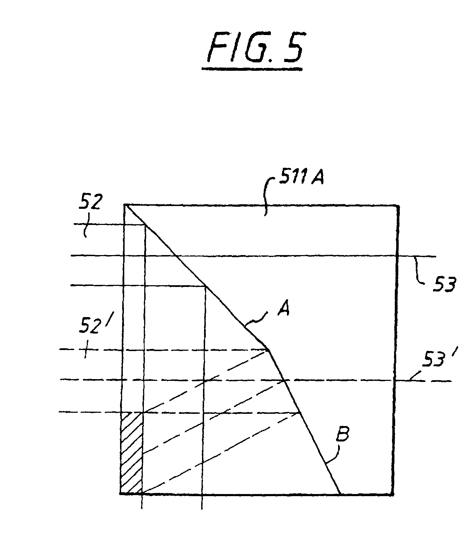

In Figur 5 ist eine weitere Variante des Strahlteilerwürfels (511A) dargestellt. Dabei ist die Strahlteilerschicht in zwei Sektionen A und B aufgeteilt.

Trifft der Bearbeitungsstrahl (52) im oberen Bereich der Strahlteilerschicht in der Sektion A auf den Strahlteilerwürfel (511A), so wird der Teilstrahl durch die Strahlaustrittsfläche (41A) ganz normal auf die in dieser Figur nicht dargestellte Werkstückoberfläche. Trifft hingegen der Bearbeitungsstrahl (52') im unteren Bereich der Strahlteilerschicht in der Sektion B auf den Strahlteilerwürfel (511A), so wird der Teilstrahl gegen eine Wand der Strahlteilungseinrichtung gelenkt, welche als Strahlabsorptionswand ausgebildet ist.

Nicht dargestellt ist ein Strahlteilerwürfel, welcher wie in Figur 4 größer als notwendig ausgeführt wurde und welcher nacheinander angeordnet mehrere Zonen mit unterschiedlichem Auskopplungsgrad besitzt.

Die verschiedenen Zonen können entlang der in Figur 4 oder Figur 5 dargestellten gestrichelten Linie angeordnet sein, welches aber den Nachteil der geringeren seitlichen Beweglichkeit des Strahlteilerwürfels beinhaltet.

Alternativ können die verschiedenen Zonen aber auch seitlich (das hieße bei Figur 5 in die Zeichnungsebene) angeordnet sein, was eine zusätzliche seitliche Beweglichkeit des Strahlteilerwürfels in der Strahlteilereinrichtung bedingen würde.

Äquivalente Überlegungen treffen natürlich auch auf den in der Figur 4 dargestellten Strahlteilerwürfel (411A) zu. Aus Übersichtlichkeitsgründen wurde auf eine Darstellung dieser Varianten verzichten.

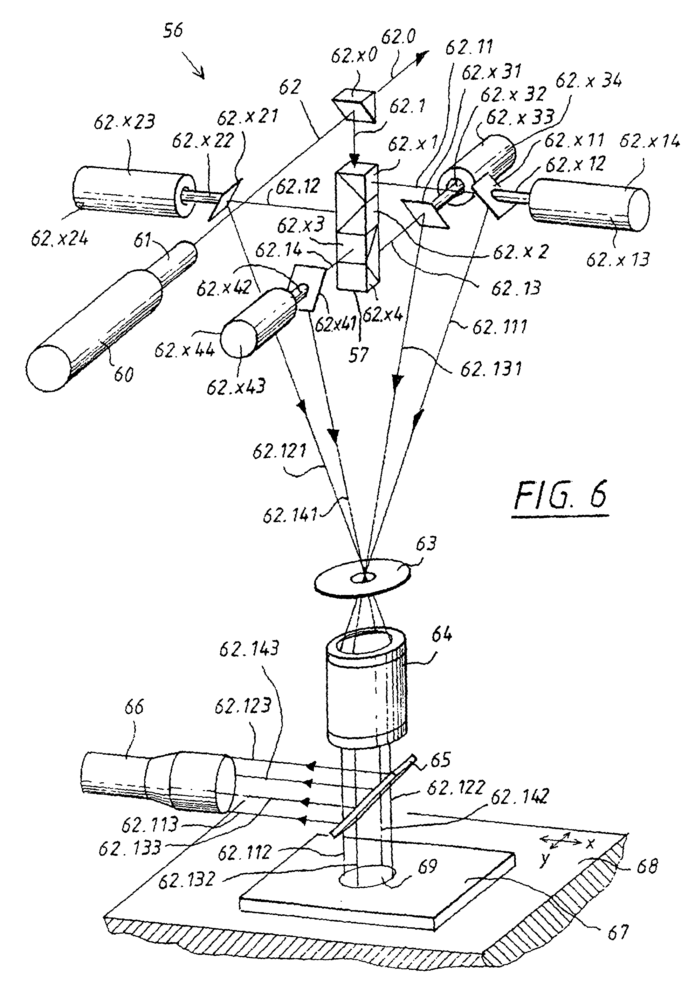

Die in der Figur 6 dargestellte erfindungsgemäße Variante des Bestrahlungsgerätes (56) besitzt als wesentliche Komponente einen Laser (60), eine bzw. mehrere Teilstrahlerzeugungseinrichtungen (62.x0, 57), Strahlablenkungseinrichtungen (62.x14, 62.x24, 62.x34, 62.x44,) für jeden Teilstrahl (62.11, 62.12, 62.13, 62.14,) eine Fangblende (63) und ein Projektionsobjektiv (64) sowie eine Beobachtungseinheit (66). Im Gegensatz zu den bekannten Einstrahl-, Mehrfach-Einstrahl- und Multistrahl-Bestrahlungsgeräten erhält man mit dem erfindungsgemäßen Bestrahlungsgerät (56) ein deutlich einfacheres Gerät, welches ggf. ohne Strahlhomogenisierung und Mikrolinsenarrays mit einem Bauvolumen wie eine einstrahlige Maschine mehrstrahlig (vorteilhafterweise z.B. vierstrahlig) arbeitet und welche zudem mit geringem Aufwand noch weiter ausgebaut werden kann.

Der verwendete und nach Stand der Technik in geeignete optische Qualität gebrachte Leistungs-Laser (60) besitzt vorteilhafterweise eine Wellenlänge von 190nm bis über 1000nm und besitzt eine mittlere Leistung von einigen mW bis einige Watt je nach Verwendungszweck des Bestrahlungsgerätes (56).

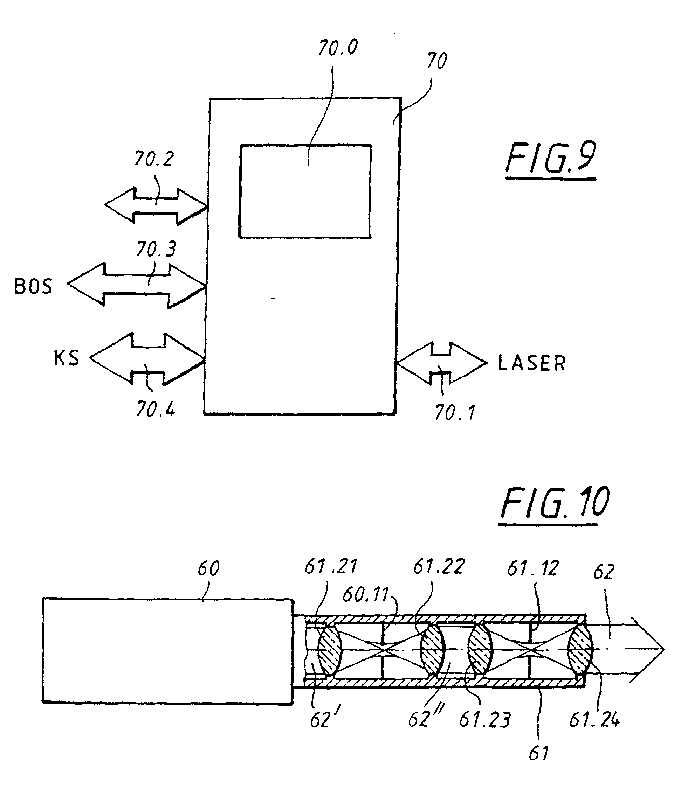

Der aus dem Laser (60) bzw. der Strahlverbesserungsvorrichtung (61) heraustretende Laserstrahl (62) (siehe Figur 10) fällt auf eine erste Einrichtung (62.x0), welche als Strahlteiler ausgeführt ist.

Da die Einrichtung (62.x0) als Strahlteiler ausgeführt, so geht ein Laserstrahl (62.0) ungestört durch die Einrichtung (62.x0) hindurch um auf eine oder mehrere weitere, der Einrichtung (62.x0) entsprechende Einrichtungen zu fallen. Die letzte der Einrichtungen sollte dabei als Reflektor ausgeführt sein. Der Strahlablenkwinkel der Einrichtungen (62.x0) beträgt vorteilhafterweise 90°, kann aber je nach Geräteauslegung auch jeweils einen anderen Winkel besitzen.

Dieser Laserstrahl (62.0) ist durch die Strahlteilung an der Strahlteilungseinrichtung (62.x0) aber in seiner Intensität geschwächt. Die Stärke der Abschwächung ist dem entsprechenden Bestrahlungsgerät (56) angepaßt und ergibt sich aus der Anzahl der Strahlteilungen des Laserstrahls (62) im entsprechenden Bestrahlungsgerät (56) hinter der Strahlteilungseinrichtung (62.x0). Der Laser (60) muß dabei so ausgelegt werden, daß auf der Oberfläche des zu bearbeitenden Werkstücks (67) die erzeugten Teilstrahlen (62.112, 62.122, 62.132, 62.142,) des Laserstrahls (62) noch eine ausreichend hohe Intensität besitzen, um die Bearbeitung des Werkstücks (67) zu ermöglichen.

Der von der vorzugsweise in einer Achse verstellbaren Einrichtung (62.x0) abgelenkte Laserstrahl (62.1) fällt auf eine Einrichtung (57) zur Erzeugung von Teilstrahlen (62.11, 62.12, 62.13, 62.14), welche in dem hier dargestellten Beispiel aus vier Strahlteilungswürfeln (62.x1, 62.x2, 62.x3, 62.x4) besteht. Die unter 45° geneigten Beschichtungsflächen (62.x1', 62.x2', 62.x3') sind dabei so ausgelegt, daß jeder der entstehenden Teilstrahlen (62.11, 62.12, 62.13, 62.14) die gleiche Energie enthält.

Jeder in einer Achse hintereinander aufgestapelte Strahlteilungswürfel (62.x1, 62.x2, 62.x3) lenkt den mit ihm erzeugten Teilstrahl (62.11, 62.12, 62.13) vorzugsweise unter einem Winkel von 90° auf einen zweiachsigen Ablenkspiegel (62.x11, 62.x21, 62.x31) einer Ablenkungseinrichtung (62.x14, 62.x24, 62.x34), wobei die Größe dieser Ablenkspiegel (62.x11, 62.x21, 62.x31) vorteilhafterweise bei 0,25 bis 4 cm² liegt. Am Ende der Einrichtung zur Erzeugung von Teilstrahlen befindet sich ein Reflektor (62.x4), der den letzten Teilstrahl (62.13) auf den Ablenkspiegel (62.x31) einer weiteren zweiachsigen Ablenkungseinrichtung (52.x34) ablenkt, wobei die Größe dieses Ablenkspiegels (62.x31) auch vorteilhafterweise bei 0,25 bis 4 cm² liegt.

Die von den Strahlteilern (62.x1, 62.x2, 62.x3) bzw. dem Reflektor (62.x4) auf die zweiachsigen Ablenkspiegel (62.x11, 62.x21, 62.x31, 62.x41) gelenkten Teilstrahlen (62.11, 62.12, 62.13, 62.14), wobei die Größe dieser im Querschnitt im wesentlichen konstant bleibenden Teilstrahlen (62.11, 62.21, 62.31, 62.14) vorteilhafterweise bei 0,25 bis 4 cm² liegt), werden von diesen Ablenkspiegeln (62.x11, 62.x21, 62.x31, 62.x41) reflektiert und diese Strahlen (62.111, 62.121, 62.131, 62.141) fallen durch das Loch der Fangblende (63) in das Projektionsobjektiv (64).

Die zweiachsigen Kippspiegel (62.x11, 62.x21, 62.x31, 52.x41) haben an ihrer Rückseite eine Kippanordnung (62.x12, 62.x22, 62.x32, 62.x42), welche mit einen Antrieb (62.x13, 62.x23, 62.x33, 62.x43) für die Kippanordnung (62.x12, 62.x22, 62.x32, 62.x42) verbunden ist.

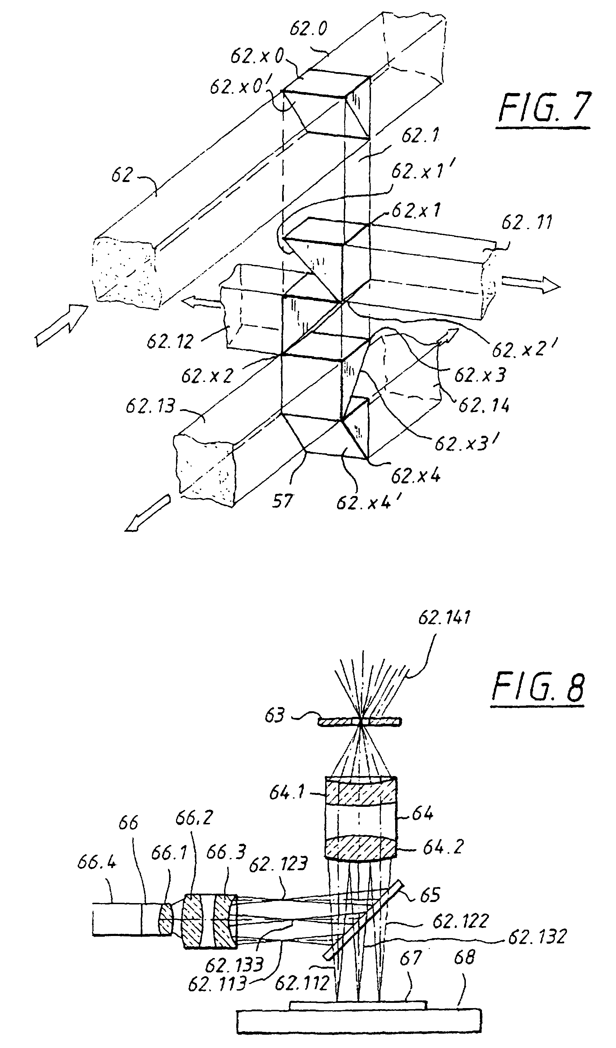

Die aus dem Projektionsobjektiv (64) fokussiert auscretenden Strahlen fallen auf einen vorzugsweise ein- und ausfahrbaren Strahlteiler (65), welcher schwache Teilszrahlen (62.113, 62.123, 62.133, 62.143) in Richtung auf eine Beobachtungseinheit (66) mit Objektiv und CCD-Kamera zur Feststellung der Einzelstrahlposition ablenkt (siehe auch Fig. 8). Die durch den Strahlteiler (65) fallenden bzw. bei Abwesenheit des Strahlteilers (65) sich ergebenden Teilstrahlen (62.112, 62.122, 62.132, 62.142) gelangen auf die Oberfläche eines Werkstücks (67) auf einem zumindest in einer Achse verstellbaren Tisch (68), dessen Verstellachse vorzugsweise senkrecht zur Verstellachse der Einrichtung (62.x0) orientiert ist. In der Figur 6 ist auch der Arbeitsbereich (69) der Teilstrahlen (62.112, 62.122, 62.132, 62.142) bei einem Bearbeitungsschritt dargestellt.

Der Laser (60), der X-Y-Tisch (68), die Beobachtungseinheit (66) und die Kippspiegel (62.x11, 62.x21, 62.x31, 62.x41) werden über eine Steuerung (70) gesteuert (welche als solche in der Figur 9 dargestellt ist).

Auf die Darstellung der Verbindungen zwischen den oben genannten Komponenten und der Steuerung sowie die Stromleitungen zu den einzelnen oben genannten Komponenten wurde aus Übersichtlichkeitsgründen in diesen Figuren verzichtet. Die Verbindungen zur Steuerung und die Energieübertragung sind gemäß dem Stand der Technik ausgeführt und können insbesondere durch Drähte oder drahtlose Verbindungen bestehen.

In der Figur 7 ist die Strahlführung des vom Laser (60) kommenden bzw. aus der Strahlverbesserungseinrichtung (61) austretenden Laserstrahls (62) an den Strahlteilern bzw. dem Reflektor (62.x0, 57) noch einmal detaillierter und übersichtlicher dargestellt.

Erfindungsgemäß werden mehrere der Teilstrahlerzeugungseinrichtungen (62.x0) hintereinander auf der optischen Achse des Laserstrahles (62) angeordnet sein, um das Werkstück (67) oder mehrere, gegebenenfalls unterschiedliche Werkstücke (in den Figuren 6-10 nicht dargestellt) an mehreren Stellen gleichzeitig bearbeiten zu können.

Diese Teilstrahlerzeugungseinrichtungen (62.x0) können auf einer oder mehreren Anordnungsachsen angeordnet sein, wobei im letzteren Fall bei dem Wechsel von einer Anordnungsachse auf eine andere zumindest ein Umlenkelement (in den Figuren nicht dargestellt) für die Umlenkung des Laserstrahls (62.0) notwendig wird.

Die Teilstrahlerzeugungseinrichtungen (62.x0) sind auf ihrer Anordnungsachse achsial verschiebbar, wobei die Verschiebung durch die in der Figur 9 dargestellten Steuerung (70) oder durch eine weitere, von der Steuerung (70) unabhängigen Steuerung veranlaßt wird.

Die letzte Teilstrahlerzeugungseinrichtung sollte ein Reflektor sein, damit aus dem Bestrahlungsgerät (56) keine Strahlen unkontrolliert oder nutzlos austreten.

Die in der Figur 7 dargestellte Teilstrahlerzeugungseinrichtung (62.x0) ist ein Strahlteiler, dessen Strahlteilungsschicht (62.x0') einen Teil des Laserstrahls (62) auf die Teilstrahlerzeugungseinrichtung (57) umlenkt. Der nicht umgelenkte Teil des Laserstahls (62.0) durchdringt den Strahlteiler (62.x0) ungestört und fällt auf einen oder weitere Teilstrahlerzeugungseinrichtungen (in den Figuren 6 bis 10 nicht dargestellt). Die Energie des Laserstrahls (62) sowie die Energieabzweigung durch die Strahlteilungsschicht (62.x0') des Strahlteilers (62.x0) ist so bemessen, daß die auf das Werkstück (67) auftreffenden Teilstrahlen dort die gewünschte Wirkung noch erzeugen können.

Der von der Teilstrahlerzeugungseinrichtung (62.x0) abgelenkte Laserstrahl (62.1) fällt auf eine weitere Teilstrahlerzeugungseinrichtung (57), welche aus einem oder mehreren Strahlteilern (62.x1, 62.x2, 62.x3) und einem Reflektor (62.x4) an ihrem Ende aufgebaut ist.

Jeder der Strahlteiler (62.x1, 62.x2, 62.x3) und der Reflektor (62.x4) am Ende der Teilstrahlerzeugungseinrichtung (57) erzeugen jeweils einen Teilstrahl (62.11, 62.12, 52.13, 62.14) an ihren Strahlteilungsoberflächen (62.x1', 62.x2', 62.x3') bzw. Reflexionsoberfläche (62.x4'). Diese Teilstrahlen (62.11, 62.12, 62.13, 62.14) fallen dann auf eine zumindest einachsige Ablenkungseinrichtung (62.x11, 62.x12, 62.x13, 62.x14, siehe Figur 6), welche aber auch zwei- (flächige Bewegung des Teilstrahls auf der Werkstückoberfläche ist möglich) oder dreiachsig (zusätzliche Fokussierung jedes einzelnen Teilstrahles ist möglich) sein kann.

Die Strahlteiler (62.x1, 62.x2, 62.x3) und der Reflektor (62.x4) sind so angeordnet, daß die durch sie erzeugten Teilstrahlen (52.11, 62.12, 62.13, 62.14) die Teilstrahlerzeugungseinrichtung (57) nicht unter demselben Winkel verlassen. Dies hat den Vorteil, daß die Ablenkungseinrichtungen (62.x11, 62.x12, 62.x13, 62.x14, siehe Figur 6) rund um die Teilstrahlerzeugungseinrichtung (57) angeordnet werden können und man so eine kompakte Gerätebauweise erhält. Der Winkel zwischen den Teilstrahlen (62.11, 62.12, 62.13, 62.14) kann dabei gerätespezifisch und/oder in Abhängigkeit von der Anzahl der Strahlteiler (62.x1, 62.x2, 62.x3) und des Reflektors (62.x4) gewählt werden.

Da in dem beispielhaft dargestellten Beispiel die Anzahl der Strahlteiler drei ist und zusätzlich ein Reflektor vorhanden ist, ergibt sich als Vorzugswinkel für die vier Teilstrahlen (62.1, 62.12, 62.13, 62.14) ein Winkel von 90°.

Die optische Achsen der von der Teilstrahlerzeugungseinrichtung (57) erzeugten Teilstrahlen (62.11, 62.12, 62.13, 62.14) fallen nicht zusammen und sind in der Höhe leicht gegeneinander versetzt. Selbstverständlich müssen die optischen Achsen der Teilstrahlen (62.11, 62.12, 62.13, 62.14) nicht senkrecht zur Achse der Teilstrahlerzeugungseinrichtung (57) sein, sondern können zu dieser jeden gewünschten Winkel besitzen.

In der Figur 8 ist der Strahlengang der Teilstrahlen nach dem Projektionsobjektiv (64) noch einmal detaillierter dargestellt. Die Beobachtungseinheit (66) besteht aus einem Objektiv mit mehreren optischen Elementen (56.1, 66.2, 66.3) (welche in dem hier dargestellten Beispiel Linsen sind), an dessen Rückseite eine Bildaufnahmeeinrichtung (66.4) (welche in dem hier dargestellten Beispiel aus einer CCD-Kamera bestehen soll) angebracht ist.

Die auf das telezentrische Objektiv (64) durch das Loch der Fangblende (63) auffallenden Teilstrahlen (62.111, 62.121, 62.131, 62.141) sind achsenparallel. in dem in der Figur 8 dargestellten Beispiel wird einer der vier Teilstrahlen (62.141) nicht benötigt und von seinem zweiachsigen Kippspiegel (62.x14) auf die Oberfläche der Fangblende (63) gelenkt, so daß er auf der Oberfläche des zu bearbeitenden Werkstücks (67) keine Wirkung mehr entfalten kann. Die Oberfläche der Fangblende (63) zumindest auf der der Teilstrahlerzeugungseinrichtung (57) zugewandten Seite ist zumindest für die verwendete Laserstrahlung strahlungsabsorbierend gestaltet und die Blende (63) als solche so ausgeführt, das selbst das Auffallen aller Teilstrahlen (62.111, 62.121, 62.131, 62.141) der Teilstrahlerzeugungseinrichtung (57) auf sie zumindest für einen gewissen Zeitraum nicht zu ihrer Zerstörung führt.

Das Projektionsobjektiv (64) selber kann aus einer oder mehreren optischen Elementen (64.1, 64.2) aufgebaut sein (in der Figur 8 sind es beispielsweise zwei Linsen) und besitzt eine optische Auslegung nach dem Stand der Technik.

Die durch das Loch der Fangblende (63) ins Projektionsobjektiv (64) fallenden achsparallelen Teilstrahlen (62.111, 62.121, 62.131) werden durch die Optik (64.1, 64.2) des Projektionsobjektivs (64) auf die Oberfläche des Werkstücks (67) auf einem X-Y-Tisch (68) so fokussiert, daß die Teilstrahlen (62.112, 62.122, 62.132) dort zumindest im wesentlichen senkrecht zur optischen Achse des Projektionsobjektivs (64) einfallen.

Vorher fallen diese Teilstrahlen (62.112, 62.122, 62.132) aber bei eingeschwenktem Strahlteiler (65) erst noch auf diesen, wobei dann energieschwache Teilstrahlen (62.113, 62.123, 62.133) erzeugt werden, welche auf die Beobachtungseinheit (66) fallen. Die optischen Elemente (66.1, 66.2, 66.3) der Beobachtungseinheit (66) selber können aus einem oder mehreren optischen Elementen aufgebaut sein (in der Figur 8 sind es beispielsweise drei Linsen) und besitzt eine optische Auslegung nach dem Stand der Technik. Hinter den optischen Elementen (66.1, 66.2, 66.3) befindet sich dann eine Bildaufnahmeeinrichtung (66.4), welche durch die auf sie auffallenden Laserteilstrahlen (62.112, 62.122, 62.132) nicht zerstört wird und welche eine Bildauswertung der Lage der Laserteilstrahlen (62.112, 62.122, 62.132) gemäß der spezifischen Geräteauslegung ermöglicht.

Die Teilstrahlerzeugungseinrichtung (62.x0) zusammen mit den Strahlteilern (62.x1, 62.x2, 62.x3) und dem Reflektor (62.x4), den Ablenkungseinrichtungen (62.x11, 62.x12, 62.x13, 62.x14), der Fangblende (63), dem Projektionsobjektiv (64) sowie der Beobachtungseinheit (66) kann man auch als eine Strahlerzeugungseinheit zusammenfassen, da sie bei einer Verstellung auf der Achse der Teilstrahlerzeugungseinrichtung (62.x0) gemeinsam bewegt werden und vorteilhafterweise in einem in den Figuren nicht dargestellten gemeinsamen Gehäuse untergebracht sind. Die Strahlerzeugungseinheit ist somit sehr kompakt und es können mehrere Strahlerzeugungseinheiten hintereinander auf einer gemeinsamen oder auf unterschiedlichen Bewegungsachsen aufgereiht sein.

Die in Figur 9 dargestellte Steuerung (70) besitzt ein Dateneingabe (70.0) (welche z.B. in einer Verbindung zu einem Computer oder aus einer Tastatur bestehen kann) und zumindest vier Datenein- und -ausgängen (70.1, 70.2, 70.3, 70.4), welche zu dem Laser (60), dem X-Y-Tisch (68) der Beobachtungseinheit (66) und zu der Strahlerzeugungseinheit führen. Die Steuerung kann aber auch zusätzlich für andere Zwecke verwendet werden, welche mit dem Ablauf der Bestrahlung durch das Bestrahlungsgerät (56) zusammenhängen (z.B. der Bewegung der Strahlerzeugungseinheit auf ihrer Bewegungsachse, welche durch den Strahl (62) vorgegeben ist).

In der Figur 10 ist die Strahlverbesserungsvorrichtung (61) noch einmal detaillierter dargestellt. Diese Strahlverbesserungsvorrichtung (61) befindet sich hinter dem Laser (60) und besteht im wesentlichen aus zwei Blenden (61.11, 61.12) und vier Zylinderlinsen (61.21, 61.22, 61.23, 61.24). Dabei ist jeweils zwischen zwei Zylinderlinsen (61.21, 61.22; 61.23, 61.24) eine Blende (61.11; 61.12) angeordnet.

Der aus dem Laser (60) austretende achsparallele Laserstrahl (62') wird durch die erste Zylinderlinse (61.21) in einer Achse fokussiert. In dem Fokus ist die erste Blende (61.11) angeordnet, welche die nicht erwünschten Strahlungsanteile entfernt. Danach weitet sich der Laserstrahl wieder auf und fällt auf die, wie die erste Linse ausgerichtete zweite Zylinderlinse (61.22), so daß sich hinter dieser zweiten Zylinderlinse (61.22) wieder ein paralleler Strahlengang für den durch sie austretenden Laserstrahl (62'') ergibt. Durch diese Anordnung (61.21, 61.11, 61.22) kann auch der Laserstrahl (62) in seinem Querschnitt in einer Achse den benötigten Dimensionen angepaßt werden.

Der Laserstrahl (62'') fällt nun auf die erste Zylinderlinse (61.23) einer zweiten Anordnung (61.23, 61.12, 61.24), welche den Laserstrahl (62'') senkrecht zu der ersten Fokussierungsachse fokussiert. Im Fokus befindet sich die zweite der Blenden (61.12), welche weitere unerwünschte Strahlungsanteile entfernt. Die nun folgende Zylinderlinse (61.24) erzeugt dann wieder einen parallelen Laserstrahl (62), welcher aus der Strahlverbesserungsvorrichtung (61) austritt. Auch durch diese zweite Anordnung (61.23, 61.12, 61.24) kann der Laserstrahl (62) in seinem Querschnitt in einer weiteren Achse den benötigten Dimensionen angepaßt werden, welche senkrecht zu der ersten Querschnittsanpassungsachse ausgerichtet ist.

Der somit erzeugte Laserstrahl (62) ist bei dem Durchgang durch die Strahlverbesserungsvorrichtung (61) in seiner Strahlqualität und seinem Strahiquerschnitt so angepaßt worden, wie er für die Verwendung in dem Bestrahlungsgerät (56) benötigt wird.

Die Maße des korrigierten Laserstahls betragen typischerweise 1*1 cm mit bis zu ca. 1Watt pro auf das Werkstück auffallendem Teilstrahl. Alle Strahlteiler und Reflektoren haben typischerweise dann eine Größe von 1*1*1 cm³, wobei die Kippspiegel eine Fläche von typischerweise 1*1 cm² haben und die Baulänge der Ablenkungseinrichtungen (62.x11, 62.x12, 62.x13, 62.x14) ca. 5 cm beträgt. Das Objektiv des Projektionsobjektivs (64) sowie der Beobachtungseinheit (66) hat dann einen Durchmesser von 20-40 mm. Der Abstand zwischen den Strahlteilern (62.x1, 62.x2, 62.x3) und dem Reflektor (62.x4) und den Ablenkungseinrichtungen (62.x11, 62.x12, 62.x13, 62.x14) braucht nur ca. 1 cm betragen und der Abstand zwischen den Strahlteilern (62.x1, 62.x2, 62.x3) und Objektiveintrittslinse des Projektionsobjektivs (64) ca. 25 cm. Je nach Geräteauslegung können aber die Maße mehr oder weniger von den hier gemachten Angaben abweichen.

Grundsätzlich erfordert die Laserbearbeitung von Metall-Kunststoff-Laminaten wie sie z.B. in der Leiterplattenindustrie üblich sind unterschiedliche Energiedichten (Metalle: hohe Energiedichten, Kunststoffe: niedrige ED). Niedere Energiedichten ergeben bei Metallen keine Bearbeitung und Kunststoffe werden bei hohen Energiedichten thermisch geschädigt.

Mit mehreren, gleichzeitig vorhandenen, geometrisch geeignet zueinanderstehenden sowie positionierbaren (Teil-)Laserstrahlen kann man dieses Problem effizient lösen, indem bis zu 7 Einzelstrahlen zur Erzeugung von Energiedichten in der Bearbeitungsebene von mehr als 7 J/cm² geeignet zusammengeführt werden.

Bei der Bearbeitung von Laminaten bestehend aus einer oberen Kupferschicht, einer mittleren Polyimidlage und einer unteren Kupferschicht erfolgt die Bearbeitung im wesentlichen in zwei Schritten.

Zuerst muß eine Bearbeitung des Metalls erfolgen. Mehrere Laser(teil-)strahlen werden telezentrisch auf die gleiche Position auf dem Kupfer gelenkt, an welcher ein Loch entstehen soll. So entstehen z.B. aus 5 Einzelstrahlen mit jeweils 0,7 J/cm² ein gemeinsamer Laserstrahl mit 3,5 J/cm², womit eine Metallbearbeitung möglich ist.

Nachdem auf diese Art alle Löcher im Metall des oberen Laminats erzeugt wurden, kommt als nächster Schritt die Bearbeitung des Kuststoffs. Dabei werden die zusammengeführten Laserstrahlen wieder auseinandergelenkt und jeder einzelne Strahl erzeugt nun separat ein Kunststoffloch durch das zuvor geschaffene Loch in der Metallschicht. Die zweite Metallschicht wirkt dabei als Stoppschicht.

Bei Bedarf kann auch die zweite Metallschicht wieder durch Zusammenlenkung mehrerer Einzel(teil-)strahlen durchbohrt werden.

Da in der Praxis die Anzahl der zu erzeugenden Löcher in einem Werkstück stets deutlich größer ist als die Anzahl der zur Verfügung stehenden Einzel(teil-)strahlen (z.B. 1.000.000 Löcher zu 100 oder 1000 Teilstrahlen) werden auch die Einzel(teil-)strahlen zum Kunststoffbohren stets effizient genutzt (und müssen nicht etwa ausgeblendet werden, was letztendlich energetisch ungünstig ist und zu einer längeren Bearbeitungszeit führt).

Die Vorteile dieser erfinderischen Lösung sind darin zu sehen, daß
- durch das Zusammenlenken einzelner Laserstrahlen die Bearbeitungsenergiedichte des wirkenden Strahls als ganzzahliges Vielfaches der Bearbeitungsenergiedichte des Einzelstrahls recht fein dosiert werden und somit der idealen Bearbeitungsenergiedichte des jeweils zu bearbeitenden Materials angepaßt werden kann;
- keine Laserenergie verschwendet wird und sich somit höchste Effizienz des eingesetzten Lasers und somit eine maximale Produktivität ergibt;
- im Vergleich zu Einzelstrahlverfahren mit einem Laser mit wenigen Watt Ausgangsleistung nun auch leistungsstarke Laser mit z.B. 50 W Ausgangsleistung effizient eingesetzt werden können; und
- die erwähnten Nachteile der Bestrahlungsgeräte nach dem Stand der Technik werden ausnahmslos vermieden.

Das erfindungsgemäße gerät ist energetisch sehr günstig und erlaubt einen sehr effektiven Einsatz von Materialbestrahlungsgeräten, welcher nach dem bekannten Stand der Technik bisher so noch nicht bekannt war.

## Patentansprüche

1. Materialbestrahlungsgerät, mit einer einen Bearbeitungsstrahl (2, 22, 32, 42, 52) erzeugenden Strahlquelle (1, 21, 31), mit mehreren auf der Achse des Bearbeitungsstrahls (2, 22, 32, 42, 52) hinter einander angeordneten Strahlteilungseinrichtungen (10A, 10B, 10C, 10D, 310A) hinter der Strahlquelle (1, 21, 31), durch die der Bearbeitungsstrahl (2, 22, 32, 42, 52) in mehrere Teilstrahlen (12A, 12B, 12C, 12C) aufgeteilt wird, wobei das zu bearbeitendes Werkstück (13A, 13B, 13C, 13D, 213A, 313A) auf einer zumindest in einer Achse beweglichen Werkstückbewegungseinrichtung (14A, 14B, 14C, 14D, 214A, 314A) aufliegt, und wobei die aus den Strahlteilungseinrichtungen (10A, 10B, 10C, 310A) austretenden Teilstrahlen gleichzeitig auf die Oberfläche des Werkstücks auf der Werkstückbewegungseinrichtung (14A, 14B, 14C, 14D, 214A, 314A) einfallend sind, **dadurch gekennzeichnet, daß** die Strahlteilungseinrichtungen (10A, 10B, 10C, 211A, 311A) in der Achse des auf sie einfallenden Bearbeitungsstrahls (2, 22, 32, 42, 52) beweglich angeordnet sind, wodurch jede der Strahlteilungseinrichtungen (10A, 10B, 10C, 211A, 311A) eine nur den von der jeweiligen Strahlteilungseinrichtung (10A, 10B, 10C, 211A, 311A) abgelenkten Teilstrahl (12A, 12B, 12C, 12D) zugeordnete Ablenkungseinrichtung bildet, durch die jeder Teilstrahl unabhängig von den anderen Teilstrahlen (12A, 12B, 12C, 12C) auf unterschiedliche Stellen des zu bearbeitenden Werkstücks (13A, 13B, 13C, 13D, 213A, 313A) lenkbar ist, und daß die Werkstückbewegungseinrichtung (14A, 14B, 14C, 14D, 214A, 314A) zumindest in einer Koordinatenrichtung bewegbar angeordnet ist, welche von der Bewegungsachse der Strahlteilungseinrichtungen (10A, 10B, 10C, 310A) abweicht, so daß jedes Flächenstück auf der Oberfläche des Werkstückes mit Strahlung beaufschlagbar ist.

2. Materialbestrahlungsgerät nach Anspruch 1, **dadurch gekennzeichnet, daß** im Materialbestrahlungsgerät eine jedem Teilstrahl (12A, 12B, 12C, 12D) diskret zugeordnete optische Einrichtung (23, 39, 41A, 41B, 41C, 41D) zur Fokussierung angebracht ist.

3. Materialbestrahlungsgerät nach Anspruch 1 oder 2, **dadurch gekennzeichnet, daß** in dem Materialbestrahlungsgerät eine Steuerung (16) für die Bewegung der Werkstückbewegungseinrichtung (14A, 14B, 14C, 14D, 214A, 314A), der Bewegung der Strahlteilungseinrichtungen (10A, 10B, 10C, 310A) und/oder Strahlumlenkeinrichtung (10D) und gegebenenfalls der Leistung der Strahlquelle (1, 21, 31) enthalten ist.

4. Materialbestrahlungsgerät nach einem der Ansprüche 1 - 3, **dadurch gekennzeichnet, daß** die Bewegungsachse der Strahlteilungseinrichtungen (10A, 10B, 10C, 310A) auf der Hauptbewegungsachse der Werkstückbewegungseinrichtung (14A, 14B, 14C, 14D, 214A, 314A) senkrecht stehend ist.

5. Materialbestrahlungsgerät nach einem der Ansprüche 1 - 4, **dadurch gekennzeichnet, daß** die Strahlquelle (1, 21, 31) ein einen Laserstrahl erzeugender Laser ist.

6. Materialbestrahlungsgerät nach einem der Ansprüche 1 - 5, **dadurch gekennzeichnet, daß** die optischen Achsen der-Teilstrahlen (12A, 12B, 12C, 12D) von der auf die Strahlteilungseinrichtung (10A, 10B, 10C, 310A) einfallenden optischen Achse (3, 33, 42, 42', 52, 52') abweichend sind.

7. Materialbestrahlungsgerät nach einem der Ansprüche 1 - 6, **dadurch gekennzeichnet, daß** die Strahlteilungseinrichtung (10A, 10B, 10C, 310A) teildurchlässige Strahlteiler (11A, 11B, 11C, 211A, 311A, 411A, 511A) aufweisen.

8. Materialbestrahlungsgerät nach einem der Ansprüche 1 - 7, **dadurch gekennzeichnet, daß** nach der Strahlquelle (1, 21, 31) und vor der Strahlteilungseinrichtung (10A, 10B, 10C, 310A) eine Strahlquerschnittsanpassungsoptik (4, 5; 6, 7; 18; 24, 25; 34, 35) angeordnet ist.

9. Materialbestrahlungsgerät nach einem der Ansprüche 1 - 8, **dadurch gekennzeichnet, daß** in bzw. nach der Strahlteilungseinrichtung (10A, 10B, 10C, 310A) eine Strahlausblendeinrichtung (36, 41D, B) angeordnet ist.

10. Materialbestrahlungsgerät nach einem der Ansprüche 1 - 9, **dadurch gekennzeichnet, daß** in der Strahlquerschnittsanpassungsoptik (4, 5; 6, 7; 24, 25; 34, 35) ein Divergenzfilter (8, 9, 28, 38) enthalten ist, welches vorzugsweise steuerbar ist, des weiteren vorzugsweise durch die Steuerung (16) steuerbar ist.

11. Materialbestrahlungsgerät nach Anspruch 2, **dadurch gekennzeichnet, daß** die jedem Teilstrahl (12A, 12B, 12C, 12D) zugeordnete optische Einrichtung (20', 20; 23, 39, 41A, 41B, 41C, 41D) mit den jeweiligen Strahlteilungseinrichtungen (10A, 10B, 10C, 310A) und/oder Strahlumlenkeinrichtungen (10D) bei deren Bewegungen fest gekoppelt sind.

12. Materialbestrahlungsgerät nach Anspruch 11, **dadurch gekennzeichnet, daß** die optische Einrichtung (39) ein Objektiv ist.

13. Materialbestrahlungsgerät nach Anspruch 12, **dadurch gekennzeichnet, daß** durch das Objektiv (39) eine Veränderung des Fokusdurchmessers des Teilstrahls (12A, 12B, 12C, 12D) auf dem Werkstück (13A, 13B, 13C, 13D, 213A, 313A) möglich ist.

14. Materialbestrahlungsgerät nach Anspruch 13, **dadurch gekennzeichnet, daß** das Objektiv (39) ein Zoom-Objektiv ist.

15. Materialbestrahlungsgerät nach Anspruch 3, **dadurch gekennzeichnet, daß** die Steuerung (16) auch für die Bewegung und vorzugsweise eine interne Steuerung der optischen Einrichtung (18, 39, 20', 20; 23, 39, 41A, 41B, 41C, 41D) zuständig ist.

16. Materialbestrahlungsgerät nach einem der Ansprüche 1-15, **dadurch gekennzeichnet, daß** die Strahlquelle (1, 21, 31, 60) ein gepulster oder dauerstrich Laser vorzugsweise mit einer Wellenlänge zwischen 190 und 3000 nm ist.

17. Materialbestrahlungsgerät nach Anspruch 16, **dadurch gekennzeichnet, daß** die Strahlquelle (1, 21, 31, 60) ein Excimerlaser ist.

18. Materialbestrahlungsgerät nach Anspruch 17, **dadurch gekennzeichnet, daß** die Strahlquelle (1, 21, 31, 60) ein frequenzverdrei- oder frequenzvervierfachter Neodym-YAG-Laser ist.

19. Materialbestrahlungsgerät nach einem der Ansprüche 1 - 18, **dadurch gekennzeichnet, daß** die Strahlquelle (1, 21, 31, 60) ein CO₂-Laser ist und daß die Materialien der optischen Komponenten für die Wellenlänge des CO₂-Lasers geeignet sind.

20. Materialbestrahlungsgerät nach einem der Ansprüche 1 - 19, **dadurch gekennzeichnet, dass** eine weitere Strahlteilungseinrichtung (62.x1 - 62x.4, 57) hinter mindestens einer der Strahlteilungseinrichtungen (62.0)vorgesehen ist, mit welcher der von der Strahlteilungseinrichtung (62.0) abgelenkte Bearbeitungsstrahl (62.1) in mehrere Teilstrahlen (62.11, 62.12, 62.13, 62.14) aufgeteilt wird, und Ablenkungseinrichtungen (62.x11, 62.x12, 62.x13, 62.x14) aufweist, wobei jedem Teilstrahl (62.11, 62.12, 62.13, 62.14) eine eigene nur ihm zugeordnete Ablenkungseinrichtung (62.x11, 62.x12, 62.x13, 62.x14)zugeordnet ist, und wobei in einem Bearbeitungsschritt jeder Teilstrahl durch die ihm zugeordnete Ablenkungseinrichtung (62.x11, 62.x12, 62.x13, 62.x14) unabhängig von den anderen Teilstrahlen (62.11, 62.12, 62.13, 62.14) auf unterschiedliche Stellen des zu bearbeitenden Werkstückes (67) lenkbar ist und alternätiv mindestens zwei, vorzugsweise mindestens vier Teilstrahlen (62.11, 62.12, 62.13, 62.14) gleichzeitig auf dieselbe Stelle des Werkstückes (67) lenkbar sind.

21. Verwendung eines Materialbestrahlungsgeräts nach einem der Ansprüche 1 - 9, **dadurch gekennzeichnet, daß** die Werkstücke (13A, 13B, 13C, 13D, 213A, 313A) Leiterplatten sind.

## Claims

1. Material irradiation device, comprising a radiation source (1, 21, 31) that produces a machining beam (2, 22, 32, 42, 52), comprising a plurality of beam splitting devices (10A, 10B, 10C, 10D, 310A) that are arranged one after another on the axis of the machining beam (2, 22, 32, 42, 52), behind the radiation source (1, 21, 31), and by means of which the machining beam (2, 22, 32, 42, 52) is subdivided into a plurality of part beams (12A, 12B, 12C, 12D), the workpiece (13A, 13B, 13C, 13D, 213A, 313A) to be machined resting on a workpiece movement device (14A, 14B, 14C, 14D, 214A, 314A) that can be moved at least in one axis, and the part beams emerging from the beam splitting devices (10A, 10B, 10C, 310A) being incident simultaneously on the surface of the workpiece on the workpiece movement device (14A, 14B, 14C, 14D, 214A, 314A), **characterized in that** the beam splitting devices (10A, 10B, 10C, 211A, 311A) are arranged such that they can move in the axis of the machining beam (2, 22, 32, 42, 52) that is incident on them, by means of which each of the beam splitting devices (10A, 10B, 10C, 211A, 311A) forms a deflection device assigned only to the part beam (12A, 12B, 12C, 12D) deflected by the respective beam splitting device (10A, 10B, 10C, 211A, 311A), by means of which device each part beam can be deflected, independently of the other part beams (12A, 12B, 12C, 12D), onto different points on the workpiece (13A, 13B, 13C, 13D, 213A, 313A) to be machined, and **in that** the workpiece movement device (14A, 14B, 14C, 14D, 214A, 314A) is arranged such that it can be moved at least in one coordinate direction, which differs from the axis of movement of the beam splitting devices (10A, 10B, 10C, 310A), so that each portion of the area on the surface of the workpiece can be acted on by radiation.

2. Material irradiation device according to Claim 1, **characterized in that**, in the material irradiation device, an optical device (23, 39, 41A, 41B, 41C, 41D) assigned discretely to each part beam (12A, 12B, 12C, 12D) is fitted for the purpose of focusing.

3. Material irradiation device according to Claim 1 or 2, **characterized in that** the material irradiation device contains a controller (16) for the movement of the workpiece movement device (14A, 14B, 14C, 14D, 214A, 314A), the movement of the beam splitting devices (10A, 10B, 10C, 310A) and/or beam deflection device (10A) and possibly the power of the radiation source (1, 21, 31).

4. Material irradiation device according to one of Claims 1 - 3, **characterized in that** the axis of movement of the beam splitting devices (10A, 10B, 10C, 310A) is at right angles to the main axis of movement of the workpiece movement device (14A, 14B, 14C, 14D, 214A, 314A).

5. Material irradiation device according to one of Claims 1 - 4, **characterized in that** the radiation source (1, 21, 31) is a laser that produces a laser beam.

6. Material irradiation device according to one of Claims 1 - 5, **characterized in that** the optical axes of the part beams (12A, 12B, 12C, 12D) differ from the optical axis (3, 33, 42, 42', 52, 52') incident on the beam splitting device (10A, 10B, 10C, 310A).

7. Material irradiation device according to one of Claims 1 - 6, **characterized in that** the beam splitting device (10A, 10B, 10C, 310A) has partially transparent beam splitters (11A, 11B, 11C, 211A, 311A, 411A, 511A).

8. Material irradiation device according to one of Claims 1 - 7, **characterized in that** after the radiation source (1, 21, 31) and before the beam splitting device (10A, 10B, 10C, 310A) there is arranged a beam cross-section adaptation optical unit (4, 5; 6, 7; 18; 24, 25; 34, 35).

9. Material irradiation device according to one of Claims 1 - 8, **characterized in that** a beam masking device (36, 41D, B) is arranged in or after the beam splitting device (10A, 10B, 10C, 310A).

10. Material irradiation device according to one of Claims 1 - 9, **characterized in that** the beam cross-section adaptation optical unit (4, 5; 6, 7; 24, 25; 34, 35) contains a divergence filter (8, 9, 28, 38), which is preferably controllable, and moreover is preferably controllable by the controller (16).

11. Material irradiation device according to Claim 2, **characterized in that** the optical device (20', 20; 23, 39, 41A, 41B, 41C, 41D) assigned to each part beam (12A, 12B, 12C, 12D) is firmly coupled to the respective beam splitting devices (10A, 10B, 10C, 310A) and/or beam deflection devices (10B) during their movements.

12. Material irradiation device according to Claim 11, **characterized in that** the optical device (39) is an objective.

13. Material irradiation device according to Claim 12, **characterized in that**, by means of the objective (39), it is possible to change the focal diameter of the part beam (12A, 12B, 12C, 12D) on the workpiece (13A, 13B, 13C, 13D, 213A, 313A).

14. Material irradiation device according to Claim 13, **characterized in that** the objective (39) is a zoom objective.

15. Material irradiation device according to Claim 3, **characterized in that** the controller (16) is also responsible for the movement and preferably internal control of the optical device (18, 39, 20', 20; 23, 39, 41A, 41B, 41C, 41D).

16. Material irradiation device according to one of Claims 1 - 15, **characterized in that** the radiation source (1, 21, 31, 60) is a pulsed or continuous output laser, preferably with a wavelength between 190 and 3000 nm.

17. Material irradiation device according to Claim 16, **characterized in that** the radiation source (1, 21, 31, 60) is an excimer laser.

18. Material irradiation device according to Claim 17, **characterized in that** the radiation source (1, 21, 31, 60) is a frequency-tripled or frequency-quadrupled Nd-YAG laser.

19. Material irradiation device according to one of Claims 1 - 18, **characterized in that** the radiation source (1, 21, 31, 60) is a CO₂ laser, and **in that** the materials of the optical components are suitable for the wavelength of the CO₂ laser.

20. Material irradiation device according to one of Claims 1 - 19, **characterized in that** a further beam splitting device (62.x1 - 62.x4, 57) is provided behind at least one of the beam splitting devices (62.0), with which the machining beam (62.1) deflected by the beam splitting device (62.0) is subdivided into a plurality of part beams (62.11, 62.12, 62.13, 62.14), and has deflection devices (62.x11, 62.x12, 62.x13, 62.x14), each part beam (62.11, 62.12, 62.13, 62.14) being assigned its own deflection device (62.x11, 62.x12, 62.x13, 62.x14) assigned only to it and, in a machining step, it being possible for each part beam to be deflected, independently of the other part beams (62.11, 62.12, 62.13, 62.14), by the deflection device (62.x11, 62.x12, 62.x13, 62.x14) assigned to it, onto different points on the workpiece (67) to be machined, and alternatively it being possible for at least two, preferably at least four, part beams (62.11, 62.12, 62.13, 62.14) to be deflected simultaneously onto the same point on the workpiece (67).

21. Use of a material irradiation device according to one of Claims 1 - 9, **characterized in that** the workpieces (13A, 13B, 13C, 13D, 213A, 313A) are printed circuit boards.

## Revendications

1. Appareil de travail de matériaux par exposition à des rayonnements, avec une source de rayonnement (1, 21, 31) générant un faisceau d'usinage (2, 22, 32, 42, 52), avec plusieurs dispositifs de séparation de faisceau (10A, 10B, 10C, 10D, 310A) disposés sur l'axe du faisceau d'usinage (2, 22, 32, 42, 52) les uns derrière les autres en aval de la source de rayonnement (1, 21, 31), par lesquels le faisceau d'usinage (2, 22, 32, 42, 52) est divisé en plusieurs faisceaux partiels (12A, 12B, 12C, 12D), moyennant quoi la pièce à usiner (13A, 13B, 13C, 13D, 213A, 313A) repose sur un dispositif de déplacement de pièce (14A, 14B, 14C, 14D, 214A, 314A) mobile au moins sur un axe, et moyennant quoi les faisceaux partiels sortant des dispositifs de séparation de faisceau (10A, 10B, 10C, 310A) arrivent en même temps sur la surface de la pièce sur le dispositif de déplacement de pièce (14A, 14B, 14C, 14D, 214A, 314A), **caractérisé en ce que** les dispositifs de séparation de faisceau (10A, 10B, 10C, 211A, 311A) sont disposés de façon mobile sur l'axe du faisceau d'usinage (2, 22, 32, 42, 52) arrivant sur eux, de sorte que chacun des dispositifs de séparation de faisceau (10A, 10B, 10C, 211A, 311A) forme un dispositif de déviation attribué seulement au faisceau partiel (12A, 12B, 12C, 12D) dévié par le dispositif de séparation de faisceau (10A, 10B, 10C, 211A, 311A) respectif, dispositif de déviation par lequel chaque faisceau partiel peut être dirigé indépendamment des autres faisceaux partiels (12A, 12B, 12C, 12D) en différents endroits de la pièce à usiner (13A, 13B, 13C, 13D, 213A, 313A), et **en ce que** le dispositif de déplacement de pièce (14A, 14B, 14C, 14D, 214A, 314A) est disposé de façon mobile au moins dans un sens de coordonnées, qui dévie de l'axe de déplacement des dispositifs de séparation de faisceau (10A, 10B, 10C, 310A), de sorte que chaque pièce de surface peut être sollicitée avec du rayonnement à la surface de la pièce.

2. Appareil de travail de matériaux par exposition à des rayonnements selon la revendication 1, **caractérisé en ce que** dans l'appareil de travail de matériaux par exposition à des rayonnements est disposé un dispositif (23, 39, 41A, 41B, 41C, 41D) optique attribué de façon discrète à chaque faisceau partiel (12A, 12B, 12C, 12D) pour la focalisation.

3. Appareil de travail de matériaux par exposition à des rayonnements selon la revendication 1 ou 2, **caractérisé en ce que** dans l'appareil de travail de matériaux par exposition à des rayonnements est incluse une commande (16) pour le déplacement du dispositif de déplacement de pièce (14A, 14B, 14C, 14D, 214A, 314A), pour le déplacement des dispositifs de séparation de faisceau (10A, 10B, 10C, 310A) et/ou du dispositif de déviation de faisceau (10D) et éventuellement pour la puissance de la source de rayonnement (1, 21, 31).

4. Appareil de travail de matériaux par exposition à des rayonnements selon l'une quelconque des revendications 1 à 3, **caractérisé en ce que** l'axe de déplacement des dispositifs de séparation de faisceau (10A, 10B, 10C, 310A) est debout verticalement sur l'axe de déplacement principal du dispositif de déplacement de pièce (14A, 14B, 14C, 14D, 214A, 314A).

5. Appareil de travail de matériaux par exposition à des rayonnements selon l'une quelconque des revendications 1 à 4, **caractérisé en ce que** la source de rayonnement (1, 21, 31) est un laser générant un faisceau laser.

6. Appareil de travail de matériaux par exposition à des rayonnements selon l'une quelconque des revendications 1 à 5, **caractérisé en ce que** les axes optiques des faisceaux partiels (12A, 12B, 12C, 12D) sont divergents par rapport à l'axe (3, 33, 42, 42', 52, 52') optique arrivant sur le dispositif de séparation de faisceau (10A, 10B, 10C, 310A).

7. Appareil de travail de matériaux par exposition à des rayonnements selon l'une quelconque des revendications 1 à 6, **caractérisé en ce que** le dispositif de séparation de faisceau (10A, 10B, 10C, 310A) présente des séparateurs de faisceau (11A, 11B, 11C, 211A, 311A, 411A, 511A) semi-argentés.

8. Appareil de travail de matériaux par exposition à des rayonnements selon l'une quelconque des revendications 1 à 7, **caractérisé en ce qu'**une optique d'adaptation de section de faisceau (4, 5 ; 6, 7 ; 18 ; 24, 25 ; 34, 35) est disposée en aval de la source de rayonnement (1, 21, 31) et en amont du dispositif de séparation de faisceau (10A, 10B, 10C, 310A).

9. Appareil de travail de matériaux par exposition à des rayonnements selon l'une quelconque des revendications 1 à 8, **caractérisé en ce qu'**un dispositif de fermeture de faisceau (36, 41D, B) est disposé dans ou en aval du dispositif de séparation de faisceau (10A, 10B, 10C, 310A).

10. Appareil de travail de matériaux par exposition à des rayonnements selon l'une quelconque des revendications 1 à 9, **caractérisé en ce que** dans l'optique d'adaptation de section de faisceau (4, 5 ; 6, 7 ; 24, 25 ; 34, 35) est inclus un filtre de divergence (8, 9, 28, 38), qui peut être de préférence commandé, et d'autre part peut être commandé de préférence par la commande (16).

11. Appareil de travail de matériaux par exposition à des rayonnements selon la revendication 2, **caractérisé en ce que** le dispositif (20', 20 ; 23, 39, 41A, 41B, 41C, 41D) optique attribué à chaque faisceau partiel (12A, 12B, 12C, 12D) est couplé de façon fixe avec les dispositifs de séparation de faisceau (10A, 10B, 10C, 310A) respectifs et/ou les dispositifs de déviation de faisceau (10D) lors de leurs déplacements.

12. Appareil de travail de matériaux par exposition à des rayonnements selon la revendication 11, **caractérisé en ce que** le dispositif (39) optique est un objectif.

13. Appareil de travail de matériaux par exposition à des rayonnements selon la revendication 12, **caractérisé en ce qu'**une variation du diamètre du foyer du faisceau partiel (12A, 12B, 12C, 12D) par l'objectif (39) est possible sur la pièce (13A, 13B, 13C, 13D, 213A, 313A).

14. Appareil de travail de matériaux par exposition à des rayonnements selon la revendication 13, **caractérisé en ce que** l'objectif (39) est un objectif à zoom.

15. Appareil de travail de matériaux par exposition à des rayonnements selon la revendication 3, **caractérisé en ce que** la commande (16) est responsable également du déplacement et de préférence pour une commande interne du dispositif (18, 39, 20', 20 ; 23, 39, 41A, 41B, 41C, 41D) optique.

16. Appareil de travail de matériaux par exposition à des rayonnements selon l'une quelconque des revendications 1 à 5, **caractérisé en ce que** la source de rayonnement (1, 21, 31, 60) est un laser pulsé ou un laser à mode continu de préférence avec une longueur d'onde comprise entre 190 et 3.000 nm.

17. Appareil de travail de matériaux par exposition à des rayonnements selon la revendication 16, **caractérisé en ce que** la source de rayonnement (1, 21, 31, 60) est un laser à excimères.

18. Appareil de travail de matériaux par exposition à des rayonnements selon la revendication 17, **caractérisé en ce que** la source de rayonnement (1, 21, 31, 60) est un laser à néodyme et YAG triplé ou quadruplé au niveau de la fréquence.

19. Appareil de travail de matériaux par exposition à des rayonnements selon l'une quelconque des revendications 1 à 18, **caractérisé en ce que** la source de rayonnement (1, 21, 31, 60) est un laser à CO₂ et **en ce que** les matériaux des composants optiques sont appropriés pour la longueur d'onde du laser à CO_{2.}

20. Appareil de travail de matériaux par exposition à des rayonnements selon l'une quelconque des revendications 1 à 19, **caractérisé en ce qu'**un autre dispositif de séparation de faisceau (62.x1 - 62x.4, 57) est prévu en aval d'au moins l'un des dispositifs de séparation de faisceau (62.0), avec lequel le faisceau d'usinage (62.1) dévié du dispositif de séparation de faisceau (62.0) est séparé en plusieurs faisceaux partiels (62.11, 62.12, 62.13, 62.14), et présente des dispositifs de déviation (62.x11, 62.x12, 62.x13, 62.x14), moyennant quoi un dispositif de déviation (62.x11, 62.x12, 62.x13, 62.x14) propre et attribué seulement au faisceau partiel est attribué à chaque faisceau partiel (62.11, 62.12, 62.13, 62.14), et moyennant quoi, lors d'une étape d'usinage, chaque faisceau partiel peut être guidé par le dispositif de déviation (62.x11, 62.x12, 62.x13, 62.x14) qui lui est attribué indépendamment des autres faisceaux partiels (62.11, 62.12, 62.13, 62.14) sur des emplacements différents de la pièce à usiner (67) et comme alternative, au moins deux, de préférence au moins quatre faisceaux partiels (62.11, 62.12, 62.13, 62.14) peuvent être guidés simultanément au même emplacement de la pièce (67).

21. Utilisation d'un appareil de travail de matériaux par exposition à des rayonnements selon l'une quelconque des revendications 1 à 9, **caractérisée en ce que** les pièces (13A, 13B, 13C, 13D, 213A, 313A) sont des cartes imprimées.
